# EUROPEAN PATENT APPLICATION

(11) **EP 2 612 958 A1**
(43) Date of publication of application: **10.07.2013**
(21) Application number: 11821966.6
(22) Date of filing: 02.09.2011
(51) Int. Cl.: C30B 29/36

(54) **METHOD FOR PRODUCING SILICON CARBIDE SINGLE CRYSTAL, SILICON CARBIDE SINGLE CRYSTAL, AND SILICON CARBIDE SINGLE CRYSTAL SUBSTRATE**

(30) Priority: 02.09.2010 JP 2010196977
(71) Applicant: Bridgestone Corporation, Tokyo 104-8340 (JP)
(72) Inventor: MIYAMOTO, Taro, Tokyo 187-8531 (JP)
(74) Representative: Lamb, Martin John Carstairs
(86) International application number: PCT/JP2011/070046
(87) International publication number: WO 2012/029952

(57) **Abstract**

In a powder fabrication step (S1) in this method for producing a silicon carbide single crystal, a metal material containing at least one of vanadium, niobium, and tungsten is mixed into silicon carbide powder as transition metal atoms for the silicon carbide powder, which is the source of silicon carbide, to produce a sublimation starting material (50). In a purification process step (S2), the sublimation starting material (50) is disposed in a purified graphite crucible (10), and a sublimation/growth step (S3) is carried out. When a growth height for this single crystal such that the donor concentration and acceptor concentration are equal in the single crystal of silicon carbide obtained by growth of sublimated raw material on a seed crystal in the sublimation/growth step (S3) is achieved, nitrogen gas is introduced at 0.5 - 100 ppm of an inert atmospheric gas.

## Description

### TECHNICAL FIELD

The present invention relates to a method of producing a silicon carbide single crystal by employing a sublimation technique, the silicon carbide single crystal produced by the method of producing, and a silicon carbide single crystal substrate.

### BACKGROUND ART

Conventionally, a technique of producing a silicon carbide single crystal as a material for a substrate for use in high frequency semiconductor device is disclosed. In the method of producing, a high resistance property of 10⁵ ohms cm or more (semi-insulating property) can be achieved by reducing a donor concentration and an acceptor concentration that are impurity concentrations included in the silicon carbide single crystal (for example, refer to Patent Literature 1).

### CITATION LIST

### PATENT LITERATURE

Patent Literature 1: Japanese Patent Application Publication (Translation of PCT Application) No. 2005-508821

### SUMMARY OF INVENTION

However, the technique disclosed in Patent Literature 1 is to achieve a high resistance by controlling the quantity of true point defects acting so as to compensate for a difference in quantity between a donor and an acceptor. Control of the number of true point defects is technically difficult, and as to a quantification technique as well, an effective approach is not established yet. Further, there is a need to manage impurity elements that can be a donor or an acceptor with its shallow level at a very low concentration. Thus, there has been a problem that costs related to management of raw materials and materials or members, or alternatively, production costs required for introduction of true point defects or the like does not meet yields.

Accordingly, it is an object of the present invention to provide a method of producing a silicon carbide single crystal producing the silicon carbide single crystal having a high resistance property, the method being capable of achieving production without a need to increase costs or working costs, the silicon carbide single crystal produced by the production method, and a silicon carbide single crystal substrate obtained by processing the silicon carbide single crystal.

To solve the above problem, the present invention has following features. A method of producing a silicon carbide single crystal, employing a production apparatus having a graphite member formed of graphite, disposing a raw material including a silicon carbide in the graphite member, and heating and sublimating the raw material and growing a single crystal of the silicon carbide on a seed crystal in an atmospheric gas, is summarized as comprising: the step of fabricating the raw material by mixing a metal material including a transient metal atom with a silicon carbide source including the silicon carbide; the step of purification treatment to retain the graphite member under a temperature condition of 2,000 degrees C or more, in an inert gas atmosphere of 100 Pa to 100 kPa; and the step of disposing the raw material in the graphite member subsequent to the step of purification treatment, and heating and sublimating the raw material and growing a silicon carbide single crystal on the seed crystal.

According to the present invention, the nitrogen concentration of a graphite member is lowered by means of the purification treatment step, whereby the nitrogen concentration in a first half of crystalline growth can be approximated to a boron concentration. In this manner, a region in which the boron concentration and the nitrogen concentration are substantially equal to each other in numeric value, i.e., a region having a semi-insulating property can be expanded.

In addition, according to the present invention, a dope quantity can be stabilized all through crystalline growth reaction by doping a metal material including at least one of titanium, vanadium, niobium, tantalum, and tungsten as a transient metal atom or mixture of metal materials including these atoms, with respect to the silicon carbide powder. In this manner, a difference in concentration between a nitrogen atom and a boron atom acting as a donor atom or an acceptor atom can be compensated for.

In the above feature of the present invention, the silicon carbide source may be a silicon carbide polycrystalline substance produced by means of a chemical vapor deposition.

In the above feature of the present invention, a donor atom may be at least any one of nitrogen, phosphorous, and arsenic, an acceptor atom may be at least either one of boron and aluminum, and the transient metal atom may be at least any one of titanium, vanadium, niobium, tantalum, and tungsten.

To solve the above problem, the present invention has following features. A silicon carbide single crystal obtained by a heating and sublimating a raw material including a silicon carbide and growing a silicon carbide single crystal on a seed crystal, in an atmospheric gas, is summarized as including a transient metal atom, wherein an absolute value of a difference between a concentration of a donor atom in the silicon carbide single crystal and a concentration of an acceptor atom is 1.0 x 10¹⁷ atoms/cm³ or less, and a concentration of the transient metal atom in the silicon carbide single crystal is 1.0 x 10¹⁶ atoms/cm³ or more and 5.0 x 10¹⁸ atoms/cm³ or less.

Moreover, the feature of the present invention is summarized as a silicon carbide single crystal substrate obtained by processing the above described silicon carbide single crystal.

### BRIEF DESCRIPTION OF DRAWINGS

[Fig. 1] Fig. 1 is a graph showing a relationship between an impurity concentration/resistivity and a single crystal growth level, wherein Fig. 1 (a) shows a relationship between the impurity concentration and the growth level, and Fig. 1 (b) shows a relationship between the resistivity and the growth level.
[Fig. 2] Fig. 2 is a sectional view illustrating an outline of a production apparatus of a silicon carbide single crystal, according to an embodiment of the present invention.
[Fig. 3] Fig. 3 is a flowchart illustrating a method of producing the silicon carbide single crystal, according to an embodiment of the present invention.
[Fig. 4] Fig. 4 (a) to Fig. 4 (c) are views showing measurement results of resistance values of sample wafers.

### DESCRIPTION OF EMBODIMENTS

A silicon carbide single crystal, a production apparatus of silicon carbide single crystals, and a method of producing silicon carbide single crystals, according to the present invention, will be described with reference to the drawings. Specifically, a description will be given with respect to (1) Description of Relationship Between growth of Silicon Carbide Single Crystal and Dopant Concentration, (2) Description of Production apparatus of Silicon Carbide Single Crystal, (3) Method of Producing Silicon Carbide Single Crystal, (4) Functions/Advantageous Effects, and (5) Other Embodiments.

In the following description of the drawings, same or like constituent elements are designated by same or like reference numerals. However, it is to be noted that the drawings are merely schematic, and ratios of the respective dimensions or the like are different from actual ones. Therefore, specific dimensions or the like should be determined in consideration of the following description. In addition, in amongst the drawings as well, the constituent elements of which dimensional interrelationships or ratios are different from each other are included.

### (1) Description of Relationship between Growth of Silicon Carbide Single Crystal and Dopant Concentration

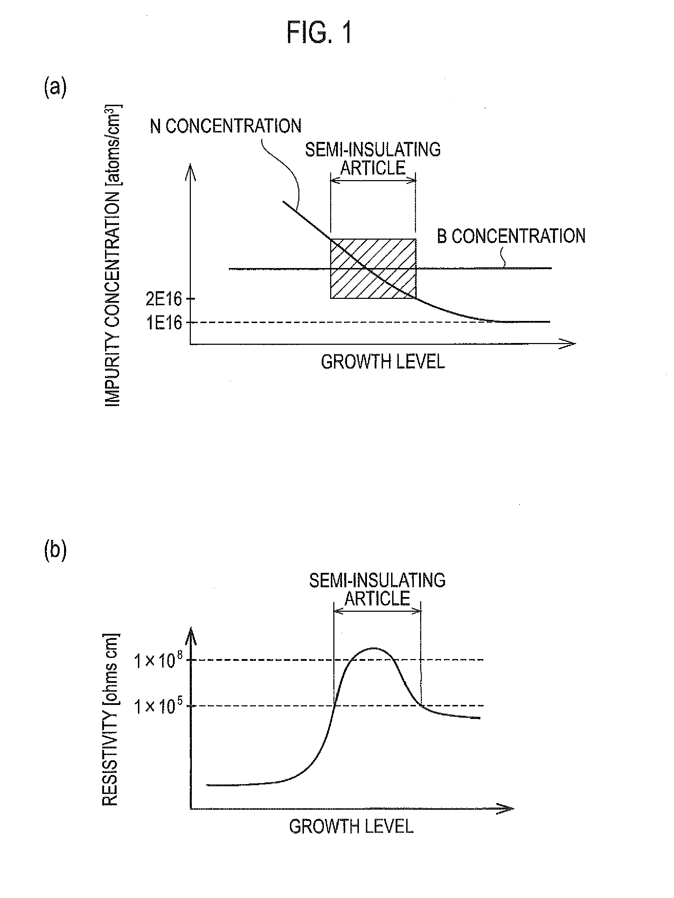

First, a relationship between growth of a silicon carbide single crystal and a dopant concentration will be described. Fig. 1 is a graph showing a relationship between an impurity concentration/resistivity and a single crystal growth level. Specifically, Fig. 1 (a) shows a relationship between the impurity concentration and the growth level, and Fig. 1 (b) shows a relationship between the resistivity and the growth level.

Among the impurities included in the silicon carbide single crystal, those which influence an electric resistance can include boron that is an acceptor with its shallow level and nitrogen that is a donor with its shallow level. Boron is included in a graphite member such as a raw material or a crucible, and it is difficult to remove it in crystalline growth. Thus, as shown in Fig. 1 (a), the boron concentration is substantially stable irrespective of whatsoever the crystalline growth level may be.

On the other hand, nitrogen is included in the graphite member such as a raw material and a crucible and in an atmospheric gas or the like. The nitrogen concentration in growing crystal lowers with crystalline growth, and finally, becomes the boron concentration or less. Concurrently, the resistivity of growing crystal, as shown in Fig. 1 (b), increases with crystalline growth; the increase in resistivity exhibits a semi-insulating property in a region in which the boron concentration and the nitrogen concentration are substantially equal to each other in numeric value (the shaded portion in Fig. 1 (a)); and subsequently, the resultant resistivity lowers with lowering of the nitrogen concentration. Therefore, in order to improve yields of a wafer with its semi-insulating property, there is a need to expand a region in which the boron concentration and the nitrogen concentration are equal to each other in numeric value.

### (2) Description of Production Apparatus of Silicon Carbide Single Crystal

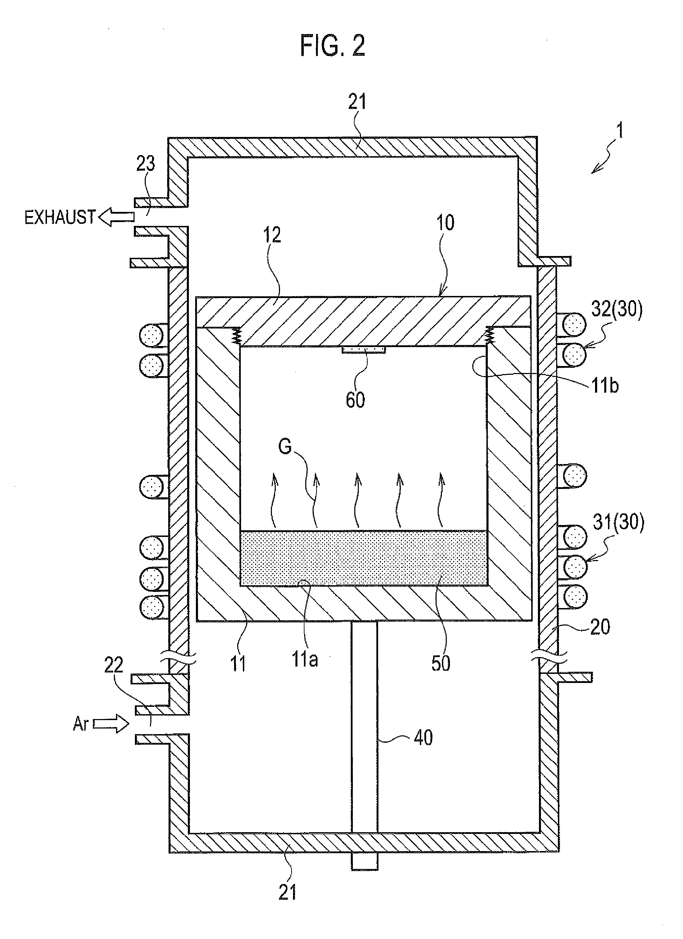

Next, a production apparatus of producing a silicon single carbide crystal, which is shown as an embodiment, will be described. Fig. 2 is a sectional view illustrating an outline of the production apparatus of the silicon carbide single crystal, according to an embodiment of the present invention.

As shown in Fig. 2, the production apparatus of the silicon carbide single crystal 1 has: a graphite crucible 10 (hereinafter, appropriately referred to as a crucible 10); a quartz tube 20 covering at least side face of the graphite crucible 10; and an inductive heating coil 30 disposed at an outer circumferential side of the quartz tube 20.

The graphite crucible 10 is made of a reaction vessel main body 11 and a capping member 12. The graphite crucible 10 is fixed inside of the quartz tube 20 by means of a supporting rod 40. A sublimation raw material 50 that is a powder including silicon carbide is housed in a bottom unit 11a of the reaction vessel main body 11. Both ends of the quartz tube 20 are sealed by means of a stainless chamber 21. At a part of the chamber 21, an argon gas flow inlet 22 adapted to flow an argon gas (Ar gas) to the inside and an exhaust outlet 23 adapted to discharge the argon gas from the inside of the quartz tube 20 are formed.

The capping member 12 closes an upper opening 11b of the reaction vessel main body 11, and is detachably provided by means of screwing on an inner circumferential face of an upper end portion of the reaction vessel main body 11. At a back face side of the capping member 12, a seed crystal 60 including silicon carbide is mounted. Means for supporting the seed crystal 60 may be mechanical bonding such as screw tightening or may be bonding exerted by means of adhesive agent.

The sublimation raw material 50 is a silicon carbide raw material of a powder including silicon carbide. When the inside of the graphite crucible 10 reaches a predetermined temperature condition and pressure condition, the sublimation raw material 50 sublimates and then a sublimation gas G is obtained. The sublimation raw material 50 recrystallizes and grows on the seed crystal 60, whereby a silicon carbide single crystal is formed.

The inductive heating coil 30 is made of: a first inductive heating coil 31 arranged at an elevation position corresponding to the bottom unit 11a of the reaction vessel main body 11; and a second inductive heating coil 32 arranged at an elevation position corresponding to the seed crystal 60 supported on the back face of the capping member 12. The supporting rod 40 is moved, and the elevation position of the graphite crucible 10 is varied, whereby the sublimation raw material 50 housed in the bottom unit 11a of the reaction vessel main body 11 is correspondingly disposed at the elevation position of the first inductive heating coil 31, and the seed crystal 60 supported by the capping member 12 can be correspondingly disposed at the elevation position of the second inductive heating coil 32.

### (3) Method of Producing Silicon Carbide Single Crystal

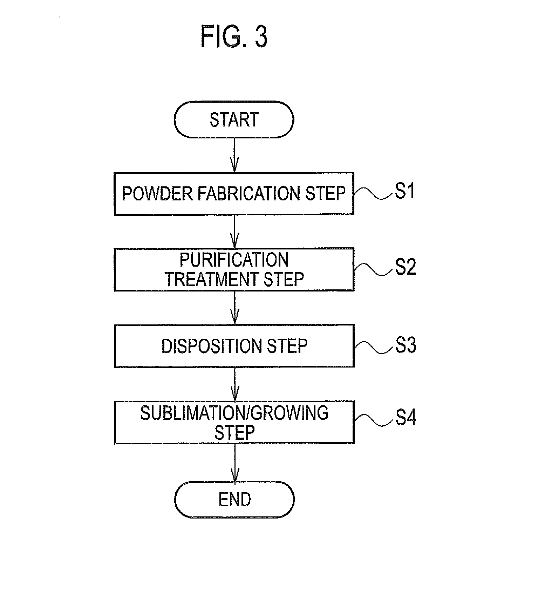

A method of producing a silicon carbide single crystal, according to an embodiment, will be described referring to Fig. 3. As shown in Fig. 3, the method of producing the silicon carbide single crystal according to the embodiment is intended to carry out the powder fabrication step S1 of fabricating the powder-like sublimation raw material 50 made of silicon carbide.

In the powder fabrication step S1, a silicon carbide source including silicon carbide is prepared. In the embodiment, as the silicon carbide source, there can be used a silicon carbide polycrystalline substance produced by means of a chemical vaporization deposition (CVD) described in Japanese Unexamined Patent Application Publication No. 2008-120C17.

With respect to this silicon carbide powder, as a transient metal atom, a metal material including at least one of titanium (Ti), vanadium (V), a niobium (Nb), tantalum (Ta), and tungsten (W) or a mixture of metal materials including these elements is doped and mixed. Under the conditions of a temperature of 2,000 degrees C to 2,350 degrees C and a pressure of 100 Pa to 10 kPa, it is preferable to dope a metal material so as to include at least an respective one of transient metal atoms of which a steam pressure is higher than that of silicon carbide (hereinafter, appropriately referred to as a high steam pressure transient metal atom) and transient metal atoms of which a steam pressure is lower than that of silicon carbide (hereinafter, appropriately referred to as a low steam pressure transient metal atom). Specifically, for example, a metal material including vanadium as the high steam pressure transient metal atom and a metal material including niobium as the low steam pressure transient metal atom are doped to the silicon carbide powder.

The high steam pressure transient metal atom include titanium and vanadium, for example. The low steam pressure transient metal atom include niobium, tantalum, and tungsten, for example.

The transient metal atom is mixed with the silicon carbide powder at a proportion of 0.001 to 0.1 atoms%, for example.

In addition, the purification treatment step S2 of graphite member such as the crucible 10 is carried out. The crucible 10 or heat insulation member is a graphite member including nitrogen more; and therefore, nitrogen including the graphite member is reduced by means of the purification treatment step S2.

In general, nitrogen of the order of some hundreds of ppm are included in the graphite member. These nitrogen exist not in pores, but in a state in which they are trapped between graphite layers or in a state in which they are replaced with carbon atoms. In order to reduce the amounts of nitrogen, the graphite member before growing a crystal is purified.

Specifically, the crucible 10 and heat insulation member are retained in an inert gas atmosphere such as argon gas. At this time, it is preferable that the pressure be set to 100 kPa or less, the temperature be set to 2,000 degrees C or more, and the crucible and heat insulation member be retained for 5 hours or more. In a pressure condition close to an atmospheric pressure as well, a sufficient nitrogen reduction effect can be obtained.

Next, the disposition step S2 is carried out. The seed crystal 60 made of the silicon carbide single crystal is mounted on a back face of the capping member 12 constituting the crucible 10 subject to the purification treatment step S2. In addition, the powder-like sublimation raw material 50 made of silicon carbide is housed in the reaction vessel main body 11, and the capping member 12 is mounted to the reaction vessel main body 11.

Next, the sublimation/growing step S4 is carried out. In the sublimation/growing step S4, the crucible 10 is heated to a temperature at which the sublimation raw material 50 sublimates (for example, to the order of 2,500 degrees C). The sublimation/growing step constitutes the heating step. The sublimation raw material 50 sublimates, the sublimation gas G is generated, and a single crystal grows from the top of the surface of the seed crystal 60.

By means of the steps described above, there can be produced a silicon carbide single crystal including a transient metal atom, in which an absolute value of a difference between the concentration of a donor atom in the silicon carbide single crystal and a concentration of an acceptor atom is 1.0 x 10¹⁷ atoms/cm³ or less, a concentration of a transient metal atom in the silicon carbide single crystal is 1.0 x 10¹⁶ atoms/cm³ or more and 5.0 x 10¹⁸ atoms/cm³ or less. In addition, a silicon carbide single crystal in which a resistivity is 1.0 x 10⁸ ohms cm or more can be produced. Further, there can be produced a silicon carbide single crystal in which a donor atom is at least any one of nitrogen, phosphorous, and arsenic; an acceptor atom is at least either one of boron and aluminum; and a transient metal atom is at least any one of titanium, vanadium, niobium, tantalum, and tungsten. Furthermore, a silicon carbide single crystal including at least respective one of the high steam pressure transient metal atom and the low steam pressure transient metal atom.

A silicon carbide single crystal substrate may be obtained by processing the silicon carbide single crystal produced by the method of producing mentioned above.

### (4) Functions/Advantageous Effects

By employing the production apparatus 1 thus treated to be purified, a raw material including silicon carbide is heated and sublimated in an atmospheric gas and then a single crystal is grown on the seed crystal 60, whereby the absolute value of a difference between the donor concentration and the acceptor concentration in the silicon carbide single crystal can be set to 1.0 x 10¹⁷ atoms/cm³ or less.

In addition, in the method of producing the silicon carbide single crystal, according to the embodiment, by carrying out the purification treatment step S2, the nitrogen concentration can be approximated to the boron concentration in the first half of crystalline growth, and the region in which the boron concentration and the nitrogen concentration are substantially equal to each other in numeric value can be expanded.

Further, in the embodiment, in the powder fabrication step S1, as the silicon carbide source, it is preferable to use the silicon carbide polycrystalline substance produced by the chemical vapor deposition (CVD) described in Japanese Unexamined Patent Application Publication No. 2008-120617.

The silicon carbide polycrystalline substance fabricated by this method is low in nitrogen concentration in comparison with silicon carbide produced by another method; and therefore, in the first half of crystalline growth, the nitrogen concentration is easily approximated to the boron concentration, and the region in which the boron concentration and the nitrogen concentration are substantially equal to each other in numeric value can be expanded.

In the embodiment, with respect to the silicon carbide powder, by doping a metal material including at least any one of titanium, vanadium, niobium, tantalum, and tungsten as a transient metal atom or a mixture of metal materials including these elements, a dope quantity can be stabilized all through crystalline growth reaction. In this manner, the concentration difference between the nitrogen atom and the boron atom acting as the donor atom or the acceptor atom can be compensated for.

In this manner, the silicon carbide single crystal having the resistivity of 1.0 x 10⁸ ohms cm or more can be produced with its high yields. Therefore, costs or working costs can be restrained. In addition, the silicon carbide single crystal having the resistivity of 1.0 x 10⁸ ohms cm or more is preferred for a material for a substrate for use in high frequency semiconductor device.

Under the condition of the temperature of 2,000 degrees C to 2,350 degrees C and the pressure of 100 Pa to 10 kPa, it is preferable to dope and mix a metal material so as to include at least a respective one of the high steam pressure transient metal atom and the low steam pressure transient metal atom. In the sublimation/growing step S4, the high steam pressure transient metal atom is evaporated more easily than silicon carbide. Thus, in the first half of crystalline growth, the high steam pressure transient metal atom is doped more in silicon carbide single crystal. Therefore, the resistance value of the silicon carbide single crystal produced in the first half of crystalline growth can be improved.

On the other hand, in the first half of crystalline growth, the high steam pressure transient metal atom is doped more and thus in the latter half of crystalline growth, a dope quantity of the high steam pressure transient metal atom is prone to decrease. The low steam pressure transient metal atom is stably doped all through crystalline growth. Therefore, in the latter half of the growth, the transient metal atom of its low steam pressure is doped more than the high steam pressure transient metal atom. In this manner, the lower steam pressure transient metal atom can be compensated for lowering of the dope quantity of the high steam pressure transient metal atom. Accordingly, the lowering of the resistivity of the silicon carbide single crystal, based on the lowering of the dope quantity of the high steam pressure transient metal atom, can be restrained.

As a result of these processes, by doping a metal material so as to include at least respective one of the high steam pressure transient metal atom and the low steam pressure transient metal atom, a difference in concentration between the nitrogen atom and the boron atom acting as the donor atom or the acceptor atom can be further compensated for all through crystalline growth. That is, the silicon carbide single crystal having the resistance value of 1.0 x 10⁸ ohms cm or more in resistivity can be further produced with its high yields.

### (5) Other Embodiments

As described above, while the contents of the present invention were disclosed through the embodiments of the present invention, it is not to be understood that discussions and drawings forming part of this disclosure limit the present invention. From this disclosure, a variety of alternative embodiments or examples would be self-evident to one skilled in the art. For example, the embodiments of the present invention can be altered as follows.

It is preferable that the silicon carbide source be powder without being limitative to the silicon carbide polycrystalline substance produced by means of the chemical vaporization deposition (CVD) described in Japanese Unexamined Patent Application Publication No. 2008-120617.

The purification treatment step S1 is possible even if an apparatus for crystalline growth or a general vacuum heating apparatus is employed. Purification treatment of a number of graphite members at one time is possible if a vacuum heating apparatus provided with a large chamber is employed.

Thus, it is a matter of course that the present invention includes a variety of embodiments or the like that are not described herein. Therefore, the technical scope of the present invention is defined only by specified matters of the invention related to the claims reasonable from the foregoing description.

### Examples

A plurality of sample wafers were fabricated under different conditions, and their resistance values were measured. With respect to a sample of Example 1, as a silicon carbide raw material, a raw material powder with its low nitrogen concentration produced by means of the chemical vapor deposition (CVD) was used. In Example 1, a treatment of purifying a graphite crucible or the like was carried out. In the purification treatment, the graphite crucible was retained for 10 hours under a condition of 90 Pa and 2,300 degrees C in an argon gas atmosphere.

In Example 1, with respect to the material powder, a commercially available vanadium carbide of 0.02 atoms% and a commercially available niobium metal of 0.05 atoms% were doped, and were homogenously mixed with each other by means of a powder mixing machine.

The thus obtained silicon carbide raw material powder was set to the graphite crucible, and crystalline growth was carried out. A SIMS (Secondary Ion Mass Spectroscopy) analysis of wafers cut out from different positions of an obtained single crystal ingot was carried out. In addition, the resistance values of the cut out and obtained wafers were measured. The cut out positions were h0: immediately above a seed crystal (that is, a growth start position) and h1: a crystalline distant end portion (that is, a growth last-stage position).

In Comparative Example 1, an item "With purification treatment" and an item "Without addition of transient metal element" were defined. In Comparative Example 2, an item "No purification treatment" and an item "With addition of transient metal elements (vanadium carbide and niobium metal)" were defined. The concentrations of dopants to be doped and the concentrations of transient metal elements are shown in Table 1.

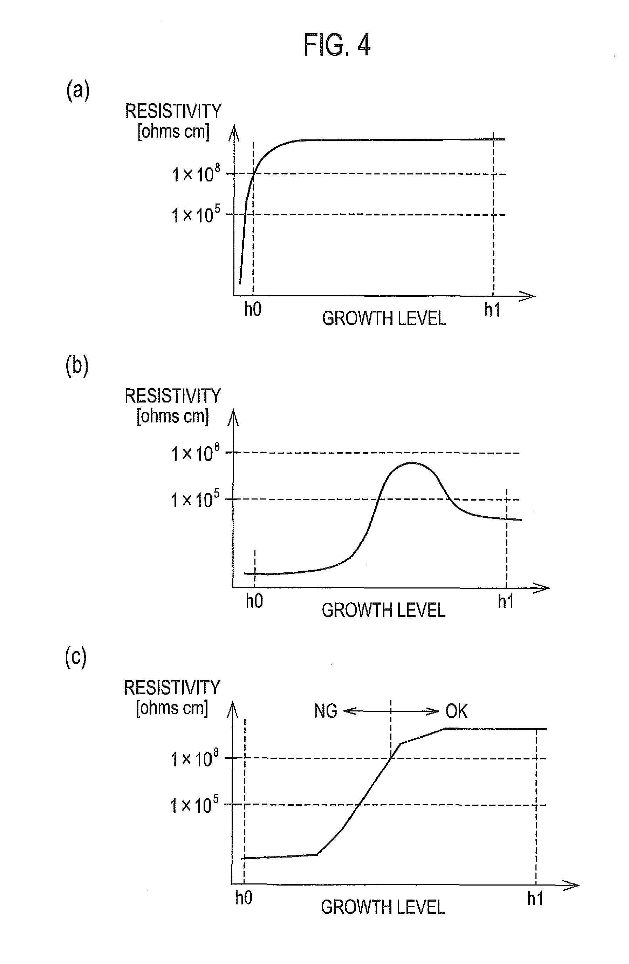

In addition, measurement results of the resistance values of the respective sample wafers are shown in Fig. 4 (a) to Fig. 4 (c).

**[Table 1]**

| | Cut position | Nitrogen concentration atoms/cm³ | Boron concentration atoms/cm³ | Absolute value of difference between donor concentration and acceptor concentration (atoms/cm³) | Vanadium element concentration atoms/cm³ | Niobium concentration atoms/cm³ | Total concentration of transient metals atoms/cm³ |
|---|---|---|---|---|---|---|---|
| Example 1 | h0 | 1.2 × 10¹⁷ | 2.6 × 10¹⁶ | 9.4 × 10¹⁶ | 2.0 × 10¹⁷ | 1.5 × 10¹⁶ | 2.2 × 10¹⁷ |
| | h1 | 4.5 × 10¹⁵ | 2.5 × 10¹⁶ | 2.1 × 10¹⁶ | 2.8 × 10¹⁴ | 1.9 × 10¹⁶ | 1.9 × 10¹⁶ |
| Comparative Example 1 | h0 | 1.1 × 10¹⁸ | 2.4 × 10¹⁶ | 1.1 × 10¹⁸ | 0 | 0 | 0 |
| | h1 | 1.3 × 10¹⁶ | 24 × 10¹⁸ | 1.1 × 10¹⁸ | 0 | 0 | 0 |
| Comparative Example 2 | h0 | 1.2 × 10¹⁸ | 2.5 × 10¹⁶ | 1.2 × 10¹⁸ | 2.2 × 10¹⁷ | 1.6 × 10¹⁸ | 1.8 × 10¹⁸ |
| | h1 | 1.3 × 10¹⁶ | 2.5 × 10¹⁸ | 1.2 × 10¹⁸ | 2.6 × 10¹⁴ | 1.9 × 10¹⁶ | 1.9 × 10¹⁶ |

In Example 1, the concentration of vanadium in a sample wafer cut out at h0 was 2.0 x 10¹⁷ atoms/cm³, and the concentration of vanadium in a sample wafer cut out at h1 was 2.8 x 10¹⁴ atoms/cm³. In addition, the concentration of niobium in the sample wafer at h0 was 1.5 x 10¹⁶ atoms/cm³, and the concentration of niobium in the sample wafer at h1 was 1.9 x 10¹⁶ atoms/cm³.

That is, it was found that vanadium carbide is doped more in a first half of growth rather than in a latter half of growth, and a dope quantity is likely to decrease with advancement of crystalline growth. On the other hand, the niobium metal was a concentration of the order of 1.0 x 10¹⁶ atoms/cm³ over the whole crystalline growth. In this way, by doping a combination of vanadium and a niobium metal, it was found that the transient metal concentration can be stabilized at 1.0 x 10¹⁶ in the first half to 1.0 x 10¹⁷ in the first half all through the growth. As shown in Fig. 5 (a), in Example 1, the resistance values of the sample wafers cut out from all the positions were 1.0 x 10⁸ ohms cm or more.

In Comparative Example 1, as shown in Fig. 5 (b), in the sample wafers cut out from all the positions as well, no solid of which a resistance value is 1.0 x 10⁸ ohms in the full face of the wafer was found. From this fact, it was found to be difficult to fabricate a wafer of which the resistance value is 1.0 x 10⁸ ohms or more in full face, in a case where only "purification treatment" is carried out and there is no dope of transient metal.

A relationship between a cut out position and a resistance value of a sample wafer in Comparative Example 2 is shown in Fig. 5 (c). From the result shown in Fig. 5 (c), even if the transient metal atom was doped, unless purification treatment was carried out, the nitrogen concentration in the first half of growth was excessive; and therefore, it was found to be difficult to fabricate a wafer of which a resistance value is 1.0 x 10⁸ ohms cm or more. As growth advanced, the nitrogen concentration in reaction system decreased; and therefore, the resistance value reached 1.0 x 10⁸ ohms cm or more; however, the yields were poor.

By carrying out the purification treatment step of the graphite member and doping a vanadium carbide (VC) and a niobium metal (Nb) simultaneously, a dope quantity could be stabilized all through the growth, and as a result, a wafer of which a resistance value is 1.0 x 10⁸ ohms or more could be generated with high yields all over its full face.

All the contents of Japanese Patent Application No. 2010-196977 (filed on September 2, 2010) are incorporated in the present specification by way of reference.

### INDUSTRIAL APPLICABILITY

According to the present invention, there can be provided the silicon carbide single crystal with its high resistance property that can be produced without a need to increase costs or working costs and a single crystal substrate that can be obtained by processing the silicon carbide single crystal. There can also be provided a method of producing that is capable of producing a silicon carbide single crystal having its high resistance property without a need to increase costs or working costs.

## Claims

1. A method of producing a silicon carbide single crystal employing a production apparatus having a graphite member formed of graphite, disposing a raw material including a silicon carbide in the graphite member, and heating and sublimating the raw material and growing a single crystal of the silicon carbide on a seed crystal in an atmospheric gas, the method comprising:
the step of fabricating the raw material by mixing a metal material including a transient metal atom with a silicon carbide source including the silicon carbide;
the step of purification treatment to retain the graphite member under a temperature condition of 2,000 degrees C or more, in an inert gas atmosphere of 100 Pa to 100 kPa; and
the step of disposing the raw material in the graphite member subsequent to the step of purification treatment, and heating and sublimating the raw material and growing a silicon carbide single crystal on the seed crystal.

2. The method of producing a silicon carbide single crystal according to claim 1, wherein
the silicon carbide source is a silicon carbide polycrystalline substance produced by means of a chemical vapor deposition.

3. The method of producing a silicon carbide single crystal according to claim 1 or 2, wherein
a donor atom is at least any one of nitrogen, phosphorous, and arsenic,
an acceptor atom is at least either one of boron and aluminum, and the transient metal atom is at least any one of titanium, vanadium, niobium, tantalum, and tungsten.

4. A silicon carbide single crystal obtained by a heating and sublimating a raw material including a silicon carbide and growing a silicon carbide single crystal on a seed crystal, in an atmospheric gas, wherein
the silicon carbide single crystal includes a transient metal atom, an absolute value of a difference between a concentration of a donor atom in the silicon carbide single crystal and a concentration of an acceptor atom is 1.0 x 10¹⁷ atoms/cm³ or less, and
a concentration of the transient metal atom in the silicon carbide single crystal is 1.0 x 10¹⁶ atoms/cm³ or more and 5.0 x 10¹⁸ atoms/cm³ or less.

5. The silicon carbide single crystal according to claim 4, wherein resistivity is 1.0 x 10⁸ ohms cm or more.

6. The silicon carbide single crystal according to claim 4 or 5, wherein the donor atom is at least any one of nitrogen, phosphorous, and arsenic,
the acceptor atom is at least either one of boron and aluminum, and the transient metal atom is at least any one of titanium, vanadium, niobium, tantalum, and tungsten.

7. The silicon carbide single crystal according to claim 4 or 5,
wherein the single crystal comprises at least a respective one of transient metal atoms of which a steam pressure is higher than that of a silicon carbide and transient metal atoms of which a steam pressure is lower than that of the silicon carbide under a condition of a temperature of 2,000 degrees C to 2,350 degrees C and a pressure of 100 Pa to 10 kPa.

8. The silicon carbide single crystal according to claim 4 or 5, wherein the transient metal atom is a combination of vanadium and niobium.

9. A silicon carbide single crystal substrate obtained by processing the silicon carbide single crystal according to any one of claims 4 to 8.
